# EUROPÄISCHE PATENTANMELDUNG

(11) **EP 3 023 795 A1**
(43) Veröffentlichungstag der Anmeldung: **25.05.2016**
(21) Anmeldenummer: 15003258.9
(22) Anmeldetag: 16.11.2015
(51) Int. Cl.: G01R 1/04, G01R 31/28

(54) **TESTKONTAKTOR, TESTKONTAKTORSYSTEM, VERWENDUNG EINES TESTKONTAKTORS UND TESTVERFAHREN**

(30) Priorität: 18.11.2014 DE 102014016996
(71) Anmelder: Yamaichi Electronics Deutschland GmbH, 85609 Aschheim-Dornach (DE)
(72) Erfinder: Quiter, Michael, 57482 Wenden (DE); Btahri, Jemei, 85609 Aschheim-Dornach (DE)
(74) Vertreter: Müller-Boré & Partner Patentanwälte PartG mbB

(57) **Zusammenfassung**

Die vorliegende Anmeldung betrifft einen Testkontaktor (10) zum Kontaktieren von Halbleiterelementen (46), umfassend: ein Gehäuse (14) mit einer Gehäuse-Bodenplatte (12) und einem Gehäuse-Deckel (78) zum Öffnen des Gehäuses (14); ein Basiselement (20), welches an der Gehäuse-Bodenplatte (12) angeordnet ist; eine Vielzahl von Kontaktierungseinheiten (38) mit jeweils zumindest einem Kontaktierungspin (48), wobei jede Kontaktierungseinheit (38) an dem Basiselement (20) angeordnet ist; zumindest eine Abdeckplatte (56), welche rückstellfähig an dem Basiselement (20) angeordnet ist und eine Vielzahl von Abdeckplatten-Pinöffnungen (70) aufweist, wobei sich ein Kontaktierungspin (48) zumindest bereichsweise in eine zugeordnete Abdeckplatten-Pinöffnung (70) erstreckt; und zumindest ein Anpresselement (84), welches im geschlossenen Zustand des Gehäuses (14) an einer der zumindest einen Abdeckplatte (56) zugewandten Seite des Gehäuse-Deckels (78) angeordnet ist, wobei das zumindest eine Anpresselement (84) im geschlossenen Zustand des Gehäuses (14) gegenüber der zumindest einen Abdeckplatte (56) angeordnet ist, und wobei im geschlossenen Zustand des Gehäuses (14) zumindest bereichsweise ein Zwischenraum zwischen der zumindest einen Abdeckplatte (56) und einer der zumindest einen Abdeckplatte (56) zugewandten Seite des Anpresselements (84) ausbildet ist, wobei in den Zwischenraum zumindest bereichsweise Halbleiterelemente (46) einsetzbar sind, so dass die Halbleiterelemente (46) von Kontaktierungspins (48) kontaktierbar sind.

## Beschreibung

Die vorliegende Erfindung betrifft einen Testkontaktor zum Kontaktieren von Halbleiterelementen, ein Testkontaktorsystem und ein Testverfahren unter Verwendung des Testkontaktors.

Testkontaktoren bieten die Möglichkeit, eine Vielzahl von Halbleiterelementen, die auf einer Leiterplatte angeordnet sind, auf ihre Funktionsfähigkeit zu überprüfen. Hierzu wird die Leiterplatte mit den Halbleiterelementen in einen Testkontaktor eingesetzt und anschließend in einem Ofen über eine vordefinierte Zeit und bei einer vordefinierten Temperatur erhitzt. Mittels der Erhitzung soll eine künstliche bzw. beschleunigte Alterung der Halbleiterelemente erzeugt werden, um altersbedingte Defekte der Halbleiterelemente untersuchen zu können. In den Testkontaktoren sind Kontaktierungspins angeordnet, die die Halbleiterelemente kontaktieren. Nach Abschluss der Erhitzungsphase werden die Kontaktierungspins mittels eines externen Auslesegeräts kontaktiert, um die Halbleiterelemente auf ihre Funktionsfähigkeit zu überprüfen.

Da in einem Testkontaktor jedoch Materialien mit unterschiedlichen Wärmeausdehnungskoeffizienten verbaut sind, wie beispielsweise Kunststoff und Metall, dehnen sich diese Materialien in der Erhitzungsphase unterschiedlich stark aus. Dies hat zur Folge, dass die Kontaktierungspins, die zur Kontaktierung der Halbleiterelemente in dem Testkontaktor vorgesehen sind, in den, aus dem Stand der Technik bekannten Testkontaktoren, häufig nach der Erhitzungsphase nicht mehr an den vorgesehenen Positionen angeordnet sind. Eine zuverlässige Kontaktierung der Halbleiterelemente ist somit nicht mehr möglich.

Es ist daher die Aufgabe der vorliegenden Erfindung, einen Testkontaktor bereitzustellen, der es ermöglicht, mit hoher Zuverlässigkeit, die auszulesenden Halbleiterelemente nach der Erhitzungsphase zu kontaktieren, um deren Funktionsfähigkeit zu überprüfen.

Diese Aufgabe wird gemäß einem ersten Aspekt durch einen Testkontaktor gelöst, der umfasst:
ein Gehäuse mit einer Gehäuse-Bodenplatte und einem Gehäuse-Deckel zum Öffnen des Gehäuses;
ein Basiselement, welches an der Gehäuse-Bodenplatte angeordnet ist;
eine Vielzahl von Kontaktierungseinheiten mit jeweils zumindest einem Kontaktierungspin, wobei jede Kontaktierungseinheit an dem Basiselement angeordnet ist;
zumindest eine Abdeckplatte, welche rückstellfähig an dem Basiselement angeordnet ist und eine Vielzahl von Abdeckplatten-Pinöffnungen aufweist, wobei sich ein Kontaktierungspin zumindest bereichsweise in eine zugeordnete Abdeckplatten-Pinöffnung erstreckt; und
zumindest ein Anpresselement, welches im geschlossenen Zustand des Gehäuses an einer der zumindest einen Abdeckplatte zugewandten Seite des Gehäuse-Deckels angeordnet ist,
wobei das zumindest eine Anpresselement im geschlossenen Zustand des Gehäuses gegenüber der zumindest einen Abdeckplatte angeordnet ist,
wobei im geschlossenen Zustand des Gehäuses zumindest bereichsweise ein Zwischenraum zwischen der zumindest einen Abdeckplatte und einer der zumindest einen Abdeckplatte zugewandten Seite des Anpresselements ausbildet ist, wobei vorzugsweise in den Zwischenraum zumindest bereichsweise Halbleiterelemente einsetzbar sind, so dass die Halbleiterelemente von Kontaktierungspins kontaktierbar sind.

In dem erfindungsgemäßen Testkontaktor ist das Basiselement "an" der Gehäuse-Bodenplatte angeordnet. Eine derartige Anordnung umfasst sowohl, dass das Basiselement auf der Gehäuse-Bodenplatte aufliegt, als auch, dass das Basiselement zumindest bereichsweise von der Gehäuse-Bodenplatte beabstandet ist. Vorteilhafterweise ist das Basiselement vollständig von der Gehäuse-Bodenplatte beabstandet. Durch eine Beabstandung der Gehäuse-Bodenplatte von dem Basiselement wird eine offene Bauweise des Testkontaktors ermöglicht, so dass die Wärme, insbesondere warme Luft, während der Erhitzungsphase in vorteilhafter Weise in den Testkontaktor einströmen kann. Das Basiselement ist vorzugsweise als Basisplatte ausgebildet.

Die Vielzahl von Kontaktierungseinheiten ist erfindungsgemäß "an" dem Basiselement angeordnet. Eine derartige Anordnung kann umfassen, dass die Kontaktierungseinheiten direkt auf dem Basiselement angeordnet sind. Es ist jedoch ebenfalls umfasst, dass die Kontaktierungseinheiten mittels eines Abstandshalters von dem Basiselement beabstandet sind, jedoch an dem Basiselement befestigt sind. Darüber hinaus kann die Vielzahl von Kontaktierungseinheiten jeweils innerhalb einer Basiselement-Öffnung angeordnet sein, wie unten näher beschrieben wird.

Eine Vielzahl von Kontaktierungseinheiten umfasst vorzugsweise zwischen 2 und 300, vorzugsweise zwischen 2 und 250 und vorzugsweise zwischen 2 und 200 Kontaktierungseinheiten. Insbesondere kann ein Testkontaktor 192 Kontaktierungseinheiten umfassen.

In jeder Kontaktierungseinheit ist zumindest ein Kontaktierungspin angeordnet, der vorzugsweise in die Kontaktierungseinheit eingebettet ist und vorzugsweise an zwei gegenüberliegenden Seiten der Kontaktierungseinheit hervorragt. In einer bevorzugten Ausführungsform weisen einzelne oder alle Kontaktierungseinheiten mehr als einen Kontaktierungspin auf, vorzugsweise 2, 3, 4, 5, 6, 7 oder 8. Neun oder mehr Kontaktierungspins innerhalb einer Kontaktierungseinheit sind jedoch ebenfalls möglich.

Die Kontaktierungspins sind innerhalb des Testkontaktors vorzugsweise derart angeordnet, dass eine Rotationsachse eines jeden Kontaktierungspins im geschlossenen Zustand des Gehäuses senkrecht zu dem Gehäuse-Deckel ausgerichtet ist. Insbesondere ist es bevorzugt, dass die Rotationsachsen der Kontaktierungspins senkrecht zu den Kontaktierungsbonds bzw. den Kontaktierungsarmen der Halbleiterelemente ausgerichtet sind, um eine zuverlässige Kontaktierung der Halbleiterelemente zu gewährleisten. Die senkrechte Ausrichtung bezieht sich dabei auf einen Zustand, in dem eine Leiterplatte in den Testkontaktor eingesetzt ist und sich der Testkontaktor im Gebrauchszustand befindet. Als Gebrauchszustand wird der Zustand des Testkontaktors verstanden, in dem das Gehäuse des Testkontaktors geschlossen ist. Im geschlossenen Zustand mit eingesetzter Leiterplatte, d.h. im Gebrauchszustand, kann der Testkontaktor in einem Ofen angeordnet sein und in dem Ofen erhitzt werden.

Erfindungsgemäß ist zumindest eine Abdeckplatte "an" dem Basiselement angeordnet. Dies kann, wie bereits oben beschrieben, umfassen, dass die Abdeckplatte auf dem Basiselement angeordnet ist, insbesondere darauf aufliegt, oder, dass die Abdeckplatte durch einen Abstandshalter von dem Basiselement beabstandet ist, jedoch an dem Basiselement befestigt ist.

Die Anzahl "zumindest eine Abdeckplatte" umfasst, dass der Testkontaktor eine Abdeckplatte aufweisen kann als auch eine Vielzahl von Abdeckplatten. Eine Vielzahl von Abdeckplatten umfasst 2, 3, 4, 5, 6, 7 oder 8 Abdeckplatten. Mehr als 8 Abdeckplatten sind jedoch ebenfalls möglich.

Weist der Testkontaktor zwei oder mehr Abdeckplatten auf, sind diese aneinander angrenzend angeordnet, vorzugsweise entlang einer Geraden. Insbesondere ist es bevorzugt, dass alle Abdeckplatten die gleiche Größe und Form aufweisen. Hier ist es bevorzugt, dass die Abdeckplatten so angeordnet sind, dass keine der Abdeckplatten bezüglich der anderen Abdeckplatten einen Überstand bildet. Mit anderen Worten ist es bevorzugt, dass die Abdeckplatten nicht zueinander versetzt angeordnet sind.

Eine rückstellfähige Anordnung der zumindest einen Abdeckplatte an dem Basiselement wird vorzugsweise durch zumindest eine Druckfeder ermöglicht, die zwischen dem Basiselement und der zumindest einen Abdeckplatte angeordnet ist. Die Druckfeder wird dabei vorzugsweise in einer entsprechenden Vertiefung in dem Basiselement gehalten. Vorteilhafterweise sind 4, 6, 8, 10, 12, 14 oder mehr Druckfedern vorgesehen.

Weist ein Testkontaktor mehr als eine Abdeckplatte auf, ist vorzugsweise jede Abdeckplatte rückstellfähig gelagert. Hierzu sind zwischen jeder Abdeckplatte und dem Basiselement vorzugsweise 2, 4, 6 oder 8 Druckfedern angeordnet.

In der zumindest einen Abdeckplatte ist eine Vielzahl von Abdeckplatten-Pinöffnungen vorgesehen. Durch eine Abdeckplatten-Pinöffnung erstreckt sich zumindest bereichsweise ein Kontaktierungspin. Vorzugsweise erstrecken sich die freien Enden der Kontaktierungspins, die dem Gehäuse-Deckel im geschlossenen Zustand des Gehäuses zugewandt sind, innerhalb der Abdeckplatten-Pinöffnungen und ragen erst durch eine rückstellfähige Bewegung der zumindest einen Abdeckplatte in eine Richtung zu dem Basiselement von der zumindest einen Abdeckplatte hervor. Mit anderen Worten ist die zumindest eine Abdeckplatte im geöffneten Zustand des Gehäuses nicht rückstellfähig zu dem Basiselement hin bewegt, so dass die Kontaktierungspins im geöffneten Zustand des Gehäuses durch die Abdeckplatte geschützt sind. Es ist jedoch ebenfalls möglich, dass die Kontaktierungspins bereits vor der rückstellfähigen Bewegung der zumindest einen Abdeckplatte in die Richtung des Basiselements von der zumindest einen Abdeckplatte hervorragen.

Zumindest ein Anpresselement ist an dem Gehäuse-Deckel angeordnet. Das zumindest eine Anpresselement ist dabei an einer Seite des Gehäuse-Deckels angeordnet, die im geschlossenen Zustand des Gehäuses einem Innenraum des Gehäuses zugewandt ist. Es handelt sich dabei um die Seite des Gehäuse-Deckels, die im geschlossenen Zustand des Gehäuses der zumindest einen Abdeckplatte gegenüber liegt. Eine derartige Anordnung umfasst, dass sich das zumindest eine Anpresselement und die zumindest eine Abdeckplatte im geschlossenen Zustand des Gehäuses zumindest bereichsweise kontaktieren, als auch, dass sich das zumindest eine Anpresselement und die zumindest eine Abdeckplatte parallel zu dem zumindest einen Anpresselement angeordnet sind, jedoch voneinander beabstandet sind.

An einer der zumindest einen Abdeckplatte zugewandten Seite des zumindest einen Anpresselements ist im geschlossenen Zustand des Gehäuses zumindest bereichsweise ein Zwischenraum ausgebildet. In diesem Zwischenraum ist die Vielzahl der Halbleiterelemente, die in den Testkontaktor einsetzbar sind, zumindest bereichsweise anordenbar bzw. einsetzbar bzw. kann in dem Zwischenraum aufgenommen sein.

Vorzugsweise weist der Testkontaktor mehrere Anpresselemente auf, vorzugsweise 2, 3, 4, 5, 6, 7, 8, 9, 10 oder mehr. Die einzelnen Anpresselemente sind vorzugsweise in entlang einer Geraden aneinander angrenzend angeordnet. Die Gesamtgröße der Anpresselemente ist dabei vorzugsweise so ausgelegt, dass sie der Größe der einzusetzenden Leiterplatte entspricht. Hierdurch kann gewährleistet werden, dass die Anpresselemente auf die gesamte Leiterplatte Druck aufbringen, um die Leiterplatte zusammen mit der zumindest einen Abdeckplatte rückstellfähig zu bewegen.

Nachdem zumindest eine Leiterplatte mit einer Vielzahl von Halbleiterelementen in den Testkontaktor eingesetzt wurde, indem die zumindest eine Leiterplatte auf die zumindest eine Abdeckplatte aufgesetzt wird, wird im üblichen Gebrauch das Gehäuse geschlossen. Im geschlossenen Zustand des Gehäuses mit eingesetzter Leiterplatte ist das zumindest eine Anpresselement mit der zumindest einen Abdeckplatte und/oder der eingesetzten Leiterplatte in Kontakt. Aufgrund des aufgebrachten Drucks des zumindest einen Anpresselements und der rückstellfähigen Lagerung der zumindest einen Abdeckplatte ist die zumindest eine Abdeckplatte rückstellfähig in Richtung zu dem Basiselement hin bewegt. Hierdurch erstrecken sich die Kontaktierungspins durch die Abdeckplatten-Pinöffnungen hindurch und ragen über die zumindest eine Abdeckplatte hinaus, so dass die Kontaktierungsarme der Halbleiterelemente kontaktiert sind.

In dieser Position wird der Testkontaktor in einem Ofen positioniert und über eine vordefinierte Zeit und bei einer vordefinierten Temperatur erhitzt. Da das Basiselement sowie die zumindest eine Leiterplatte vorzugsweise aus Metall oder einer Metalllegierung gefertigt sind, während die einzelnen Kontaktierungseinheiten sowie die zumindest eine Abdeckplatte vorzugsweise aus Kunststoff gefertigt sind, dehnen sich die verschiedenen Elemente aufgrund unterschiedlicher Wärmeausdehnungskoeffizienten unterschiedlich stark aus. Üblicherweise weist Kunststoff einen höheren Wärmeausdehnungskoeffizienten auf als Metall. Somit dehnen sich das Basiselement und die Leiterplatte in ähnlich stark aus, während sich die Kontaktierungseinheiten stärker ausdehnen als das Basiselement und die Leiterplatte.

Der erfindungsgemäße Testkontaktor bietet den Vorteil, dass aufgrund der Vielzahl von Kontaktierungseinheiten, die separat voneinander ausgestaltet sind, diese Differenz der Wärmeausdehnungskoeffizienten kompensiert werden kann. Die unterschiedlich starke Ausdehnung der einzelnen Kontaktierungseinheiten im Vergleich zu dem Basiselement und der Leiterplatte ist hierdurch derart gering, dass diese vernachlässigbar ist. Mit anderen Worten ist eine Verschiebung der Kontaktierungspins, die in den einzelnen Kontaktierungseinheiten angeordnet sind, derart gering, dass auch nach dem erhitzten Zustand bzw. im erhitzten Zustand eine zuverlässige Kontaktierung der Kontaktierungsarme bzw. Kontaktierungsbonds der Halbleiterelemente gewährleistet werden kann.

Vorzugsweise weist das Basiselement eine Vielzahl von Basiselement-Öffnungen auf, wobei in jeder der Basiselement-Öffnungen eine Kontaktierungseinheit angeordnet ist.

Durch die Basiselement-Öffnungen, die in dem Basiselement ausgebildet sind, kann die Ausdehnung der einzelnen Kontaktierungseinheiten, die in die Basiselement-Öffnungen eingesetzt sind, weiterhin limitiert werden. Die Kontaktierungseinheiten stehen zwar dadurch unter Spannung, die Position der Kontaktierungspins verändert sich jedoch nur minimal. Vorzugsweise wird die Position der Kontaktierungspins nicht verändert. In Folge dessen kann in einer verbesserten Weise die Position der Kontaktierungspins gehalten werden, so dass trotz der verschiedenen Wärmeausdehnungskoeffizienten der verschiedenen in dem Testkontaktor verwendeten Materialien die Position der Kontaktierungspins präzise und vorhersehbar bestimmt werden kann.

Die Anzahl der Basiselement-Öffnungen kann an die Anzahl der Kontaktierungseinheiten angepasst sein. Es ist jedoch ebenfalls möglich, dass die Anzahl der Basiselement-Öffnungen höher ist als die Anzahl der tatsächlich eingesetzten Kontaktierungseinheiten. Durch eine Bereitstellung einer höheren Anzahl von Basiselement-Öffnungen ist der Testkontaktor sehr variabel. Durch eine Variation der Anzahl von in die Basiselement-Öffnungen eingesetzten Kontaktierungseinheiten können unterschiedlich große sowie unterschiedliche bestückte Leiterplatten getestet werden. Mit anderen Worten ist der Testkontaktor an die Anzahl der zu testenden Halbleiterelemente anpassbar.

Weiterhin ist es möglich, dass aufgrund der Basiselement-Öffnungen das jeweilige andere freie Ende der Kontaktierungspins das Basiselement durchdringt, um vorzugsweise über eine Öffnung in der Gehäuse-Bodenplatte von einem externen Auslesegerät kontaktierbar zu sein.

Vorzugsweise entspricht die Form und Größe einer Basiselement-Öffnung einem Bereich einer Außenflächenform einer zugeordneten Kontaktierungseinheit, die in der Basiselement-Öffnung angeordnet ist.

Als "Außenfläche" der Kontaktierungseinheit wird dabei die Fläche angesehen, die der Innenfläche der Basiselement-Öffnung im eingesetzten Zustand der Kontaktierungseinheit gegenüber liegt bzw. die die Innenfläche der Basiselement-Öffnung kontaktiert bzw. die an der Innenfläche der Basiselement-Öffnung anliegt.

Vorzugsweise weist die zumindest eine Abdeckplatte eine Gitterstruktur auf.

Eine Gitterstruktur bietet den Vorteil, dass sich die Wärme, insbesondere die warme Luft, in der Erhitzungsphase in vorteilhafter Weise in dem Testkontaktor in Richtung der einzusetzenden Leiterplatte ausbreiten kann.

Weist ein Testkontaktor eine Vielzahl von Abdeckplatten auf, weist vorzugsweise jede Abdeckplatte eine Gitterstruktur auf.

In einer bevorzugten Ausführungsform umfasst die Gitterstruktur Gitterstreben, in denen die Vielzahl von Abdeckplatten-Pinöffnungen angeordnet sind und
wobei an einer dem Basiselement zugewandten Seite der Gitterstreben zumindest in Bereichen, in denen die Abdeckplatten-Pinöffnungen angeordnet sind, zumindest eine Abdeckplatten-Vertiefung ausgebildet ist, in die die Kontaktierungseinheiten hineinragen.

Die Gitterstruktur wird aus einer Vielzahl von Gitterstreben gebildet. Ein Teil der Vielzahl der Gitterstreben ist parallel beabstandet voneinander angeordnet und wird von einem anderen Teil der Vielzahl von Gitterstreben, die ebenfalls parallel beabstandet zueinander angeordnet sind, überkreuzt. Der Winkel in dem sich die Gitterstreben überkreuzen, ist dabei frei wählbar. Vorzugsweise überkreuzen sich die Gitterstreben in einem Winkel zwischen 50 und 120° und vorzugsweise zwischen 60° und 90°. Im Speziellen ist es bevorzugt, die sich die Gitter in einem Winkel von 90° überkreuzen. Je nach Abstand der Gitterstreben, die parallel zueinander angeordnet sind, sind in der Gitterstruktur entsprechend große Gitteröffnungen ausgebildet. Die Gitterstreben können durchgängige Gitterstreben sein oder unterbrochen sein. Als Unterbrechung kann beispielsweise eine Bohrung in einer Gitterstrebe angesehen werden, in die eine Schraube einsetzbar ist. Vorzugsweise weisen die Gitterstreben zumindest eine Bohrung auf, in die eine Schraube einsetzbar ist, um die zumindest eine Abdeckplatte an dem Basiselement zu befestigen.

Darüber hinaus weisen die Gitterstreben Abdeckplatten-Pinöffnungen auf, in die die Kontaktierungspins hineinragen. Die Abdeckplatten-Pinöffnungen weisen vorzugsweise einen Durchmesser zwischen 0,1mm und 0,8mm, vorzugsweise zwischen 0,15mm und 0,7mm und vorzugsweise zwischen 0,25mm und 0,55mm. Vorzugsweise weisen die Abdeckplatten-Pinöffnungen einen Durchmesser von 0,25mm oder 0,55mm auf. Die einzusetzenden Kontaktierungspins bzw. der Bereich der Kontaktierungspins, der in den Abdeckplatten-Pinöffnungen angeordnet ist weist/weisen vorzugsweise einen Durchmesser zwischen 0,05mm und 0,6mm, vorzugsweise zwischen 0,15mm und 0,4mm und vorzugsweise zwischen 0,25mm und 0,35mm auf. Insbesondere kann der einzusetzende Kontaktierungspin einen Durchmesser von 0,3mm aufweisten. Ist der Durchmesser der Abdeckplatten-Pinöffnungen 0,25mm ist vorzugsweise ein Kontaktierungspin mit einem Durchmesser von 0,15mm eingesetzt. Ist der Durchmesser der Abdeckplatten-Pinöffnung 0,55mm ist vorzugsweise ein Kontaktierungspin mit einem Durchmesser von 0,25mm eingesetzt. Vorzugsweise ist die Gesamtlänge eines Kontaktierungspins zwischen 2mm und 8mm, vorzugsweise zwischen 3mm und 6mm und vorzugweise 5,7mm. Sobald die zumindest eine Abdeckplatte eine rückstellfähige Bewegung in Richtung des Basiselements ausgeführt hat, ragen die Kontaktierungspins vorzugsweise über die zumindest eine Abdeckplatte hinaus, um die Kontaktierungsarme bzw. Kontaktierungsbonds der Halbleiterelemente zu kontaktieren. Vorzugsweise weisen die Gitterstreben Abdeckplatten-Pinöffnungen in der entsprechenden Anzahl der Kontaktierungspins, die in die Abdeckplatten-Pinöffnungen hinein ragen, auf. Es ist jedoch ebenfalls möglich, dass die Anzahl der Abdeckplatten-Pinöffnungen höher ist als die Anzahl der Kontaktierungspins. Hierdurch wird ermöglicht, dass der Testkontaktor variabel ausgestaltet ist. Wird die Anzahl der Kontaktierungspins durch beispielsweise einen Austausch der Kontaktierungseinheiten verändert, kann die zumindest eine Abdeckplatte unverändert weiter verwendet werden. Vorzugsweise weisen die Gitterstreben in einem Bereich, in dem die Gitterstrebe eine Kontaktierungseinheit überlappt, 2, 3, 4, 5, 6, 7 oder 8 Abdeckplatten-Pinöffnungen auf. Neun oder mehr Abdeckplatten-Pinöffnungen sind jedoch ebenfalls möglich. Die genannten Zahlen beziehen sich jedoch nur auf jeweils einen Bereich in der Gitterstrebe, die eine Kontaktierungseinheit überlappt. Da eine Gitterstrebe jedoch vorzugsweise mehrere Kontaktierungseinheiten überlappt, erhöht sich die Anzahl der Abdeckplatten-Pinöffnungen entsprechend. Mit anderen Worten ist die Anzahl der Abdeckplatten-Pinöffnungen an die Anzahl der eingesetzten Kontaktierungseinheiten bzw. die Anzahl der eingesetzten Kontaktierungspins und an die Anzahl der einzusetzenden Halbleiterelemente anpassbar.

Vorzugsweise ist der Durchmesser jeder Abdeckplatten-Pinöffnung größer ausgebildet als der Durchmesser eines Kontaktierungspins, um an die Stärke der Ausdehnung der zumindest einen Abdeckplatte in erhitzten Zustand angepasst zu sein. Vorzugsweise ist der Durchmesser jeder Abdeckplatten-Pinöffnung um vorzugsweise 20% bis 75%, vorzugsweise 40% bis 60% und vorzugsweise 45% bis 50% größer dimensioniert als der Durchmesser eines eingesetzten Kontaktierungspins. Insbesondere ist der Durchmesser der Abdeckplatten-Pinöffnungen vorzugsweise um 20% größer als der Durchmesser eines einzusetzenden Kontaktierungspins.

Vorzugsweise weist im geschlossenen Zustand des Gehäuses das zumindest eine Anpresselement an der der zumindest einen Abdeckplatte zugewandten Seite zumindest eine Anpresselement-Aussparung auf, die derart ausgelegt ist, dass Halbleiterelemente darin aufnehmbar sind.

Die Anpresselement-Aussparung kann dabei derart ausgebildet sein, dass alle Halbleiterelemente, die auf der Leiterplatte ausgebildet sind, in diese Anpresselement-Aussparung vorragen bzw. hineinragen bzw. darin angeordnet sein können, wenn das Gehäuse geschlossen ist. Alternativ kann jedoch auch eine Vielzahl von Anpresselement-Aussparungen ausgebildet sein, in die jeweils eine oder eine Vielzahl von Halbleiterelementen angeordnet sein können, wenn das Gehäuse geschlossen ist.

Das zumindest eine Anpresselement ist zumindest bereichsweise mit der zumindest einen einzusetzenden Leiterplatte in Kontakt, wenn das Gehäuse geschlossen ist. Das zumindest eine Anpresselement übertragt hierbei eine Kraft, die von dem geschlossenen Gehäuse-Deckel aufgebracht wird, auf die eingesetzte Leiterplatte bzw. die zumindest eine Abdeckplatte. Hierdurch ist die zumindest eine Abdeckplatte im geschlossenen Zustand des Gehäuses rückstellfähig in Richtung zu dem Basiselement verschoben. Ist das zumindest eine Anpresselement größer ausgestaltet als die einzusetzenden Leiterplatte, kann das zumindest eine Anpresselement auch bereichsweise mit der zumindest einen Abdeckplatte im geschlossenen Zustand des Gehäuses in Kontakt treten.

Als "Aussparungstiefe" der Anpresselement-Aussparung wird das Größenmaß angesehen, das die Anpresselement-Aussparung in einer Richtung senkrecht zu der zumindest einen Abdeckplatte im geschlossenen Zustand des Gehäuses aufweist.

Die Aussparungstiefe der zumindest einen Anpresselement-Aussparung ist derart ausgebildet, dass die Halbleiterelemente darin anordenbar sind.

Vorzugsweise weist die Gehäuse-Bodenplatte zumindest eine Bodenplatten-Öffnung auf, die derart angeordnet ist, dass die Kontaktierungseinheiten durch eine externe Ausleseeinheit kontaktierbar sind.

Über eine Bodenplatten-Öffnung ist der Innenbereich des Testkontaktors von außen zugänglich. Über eine externe Ausleseeinheit, die außerhalb des Testkontaktors angeordnet ist, kann die Kontaktierungseinheit, insbesondere können die Kontaktierungspins, kontaktiert werden, um die Funktionsfähigkeit der Halbleiterelemente zu testen. Eine externe Ausleseeinheit kann durch eine externe Leiterplatte (PCB) mit elektronischen Bauelementen ausgebildet sein. Der Ausleseprozess findet vorzugsweise jedoch erst statt, nachdem die Halbleiterelemente über eine bestimmte Zeit erhitzt wurden. Durch die Kontaktierung der Halbleiterelemente mittels der Kontaktierungspins über die Bodenplatten-Öffnung kann eine Entnahme der Leiterplatte aus dem Testkontaktor vermieden werden.

Die Bodenplatten-Öffnung kann eine Größe aufweisen, die es ermöglicht, dass alle Kontaktierungseinheiten zugänglich sind. Es ist jedoch auch möglich, dass mehrere Bodenplatten-Öffnungen in der Gehäuse-Bodenplatte bereitgestellt sind und über jede der Bodenplatten-Öffnungen eine entsprechende Anzahl von Kontaktierungseinheiten kontaktierbar ist. Vorzugsweise weist eine Gehäuse-Bodenplatte 2, 3, 4, 5, 6 ,7 oder mehr Bodenplatten-Öffnungen auf.

Vorzugsweise ist das Basiselement von der Gehäuse-Bodenplatte mittels zumindest einem Abstandshalter beabstandet.

Eine Beabstandung kann beispielsweise mittels mindestens einem separat ausgebildeten Abstandshalter realisiert werden, der zwischen der Gehäuse-Bodenplatte und dem Basiselement angeordnet ist. Es ist jedoch ebenfalls möglich, dass das Basiselement und/oder die Gehäuse-Bodenplatte jeweils zumindest einen Vorsprung aufweist/aufweisen, der/die in eine Richtung zu dem anderen Bauteil vorspringt/vorspringen, um die beiden Elemente voneinander zu beabstanden.

Ein Abstandshalter kann beispielsweise durch einen zylinderförmigen Abstandshalter realisiert sein. Um das Basiselement an der Gehäuse-Bodenplatte zu befestigen, kann dieser zylindrische Abstandshalter hohl ausgebildet sein. In dem hierdurch gebildeten Hohlraum in dem Abstandshalter kann vorzugsweise eine Schraube angeordnet sein, mittels der das Basiselement an der Gehäuse-Bodenplatte befestigt ist.

Vorzugsweise weist der Testkontaktor zwischen 2 und 30, vorzugsweise zwischen 5 und 25 und vorzugsweise zwischen 10 und 20 Abstandshalter auf.

Durch den zumindest einen Abstandshalter weist der Testkontaktor eine offene Bauweise auf, so dass Wärme, insbesondere warme Luft, in der Erhitzungsphase in vorteilhafter Weise in den Testkontaktor eindringen kann.

Vorzugsweise ist das zumindest eine Anpresselement rückstellfähig an dem Gehäuse-Deckel gelagert.

Durch eine rückstellfähige Lagerung des zumindest einen Anpresselements an dem Gehäuse-Deckel ist der Abstand zwischen dem Anpresselement und der zumindest einen Abdeckplatte bzw. der zumindest einen einzusetzenden Leiterplatte anpassbar. Insbesondere sind hierdurch Unebenheiten der Leiterplatte oder der zumindest einen Abdeckplatte ausgleichbar, um beim Schließen des Gehäuse-Deckels gleichmäßig Druck auf die gesamte Leiterplatte bzw. die Abdeckplatte aufbringen zu können. Unebenheiten in einer Leiterplatte können sich beispielsweise aus Fertigungstoleranzen ergeben.

Eine rückstellfähige Lagerung kann mittels zumindest einer Druckfeder realisiert werden, die zwischen dem Gehäuse-Deckel und dem zumindest einen Anpresselement angeordnet ist. Vorzugsweise sind zwischen dem zumindest einen Anpresselement und dem Gehäuse-Deckel zwischen 2 und 100, vorzugsweise zwischen 10 und 90 und vorzugsweise zwischen 20 und 80 Druckfedern angeordnet. Weist der Testkontaktor eine Vielzahl von Anpresselementen auf, ist zwischen jedem Anpresselement und dem Gehäuse-Deckel zumindest eine Druckfeder angeordnet.

Es ist weiterhin bevorzugt, dass zumindest ein Positionierungspin an einer der zumindest einen Abdeckplatte zugewandten Seite des Basiselements angeordnet ist und der sich durch die zumindest eine Abdeckplatte hindurch erstreckt,
wobei der zumindest eine Positionierungspin derart angeordnet ist, dass dieser in eine Leiterplatten-Öffnung einer einzusetzenden Leiterplatte einsetzbar ist.

Der Positionierungspin dient dazu, die einzusetzende Leiterplatte an einer Position innerhalb des Testkontaktors zu fixieren. Hierzu wird der Positionierungspin in eine Leiterplatten-Öffnung in der einzusetzenden Leiterplatte eingesetzt, die in der Leiterplatte üblicherweise ausgebildet ist, um einen Referenzpunkt in der Leiterplatte zu bilden. Mittels des Referenzpunktes ist die Position jedes Halbleiterelements während des Herstellungsprozesses der Leiterplatte definiert als auch in der fertigen Leiterplatte exakt bestimmt. Vorzugsweise definiert der Referenzpunkt einen Koordinatenursprung, von dem aus der Abstand zu den einzelnen Halbleiterelementen und die Position der einzelnen Halbleiterelemente festgelegt sind.

Vorzugsweise weist ein Testkontaktor 2, 4, 6, 8 oder mehr Positionierungspins auf.

Durch die Positionierung des Positionierungspins ist es nicht notwendig eine neue Leiterplatten-Öffnung in der Leiterplatte bereitzustellen. Es wird lediglich eine Leiterplatten-Öffnung verwendet, die in einer Leiterplatte bereits vorhanden ist. Darüber hinaus ist die Position der Halbleiterelemente und der Kontaktierungsbonds in dem Testkontaktor bekannt.

Gemäß einem zweiten Aspekt der vorliegenden Erfindung wird die zugrunde liegende Aufgabe durch ein Testkontaktorsystem gelöst, das einen Testkontaktor gemäß einem der vorangehend beschriebenen Testkontaktoren; und
zumindest eine Leiterplatte mit einer Vielzahl von Halbleiterelementen, die in den Testkontaktor eingesetzt ist, umfasst.

Vorzugsweise ist die zumindest eine Leiterplatte austauschbar in den Testkontaktor eingesetzt.

Dies ermöglicht, dass der Testkontaktor mehrfach wiederverwendet werden kann. Lediglich die Leiterplatten mit den zu testenden Halbleiterelementen sind auszutauschen. Im geöffneten Zustand des Gehäuses ist eine Leiterplatte austauschbar.

Es ist bevorzugt, dass in dem Testkontaktorsystem zumindest ein Positionierungspin an einer der zumindest einen Abdeckplatte zugewandten Seite des Basiselements angeordnet ist und sich der zumindest eine Positionierungspin durch die zumindest eine Abdeckplatte hindurch erstreckt,
wobei die zumindest eine Leiterplatte zumindest eine Leiterplatten-Öffnung aufweist, in die der zumindest eine Positionierungspin zur Positionierung der Leiterplatte eingesetzt ist.

Gemäß einem dritten Aspekt der vorliegenden Erfindung wird die zugrunde liegende Aufgabe durch die Verwendung eines Testkontaktors gemäß einem der oben beschriebenen Ausführungsformen zum Testen von Halbleiterelementen gelöst.

Gemäß einem vierten Aspekt der vorliegenden Erfindung wird ein Testverfahren zum Testen von Halbleiterelementen bereitgestellt, das umfasst:
Bereitstellen eines Testkontaktors gemäß einem der oben beschriebenen Ausführungsformen;
Einsetzen einer Leiterplatte;
Schließen des Gehäuses;
Rückstellfähiges Bewegen der zumindest einen Abdeckplatte in eine Richtung zu dem Basiselement durch eine Anpresskraft, der im geschlossenen Zustand des Gehäuse-Deckels mittels des zumindest einem Anpresselements auf die zumindest eine Abdeckplatte wirkt, so dass die Halbleiterelemente durch Kontaktierungspins kontaktiert werden;
Erhitzen des Testkontaktors mit der zumindest einen eingesetzten Leiterplatte auf eine vordefinierte Temperatur über eine vordefinierte Zeit; und
Kontaktieren der Halbleiterelemente von einer Außenseite des Gehäuses durch ein externes Auslesegerät und Testen der Halbleiterelemente.

Vorzugsweise werden die Halbleiterelemente bzw. der Testkontaktor bei einer Temperatur zwischen -100°C und 250°C, vorzugsweise zwischen -40°C und 150°C und vorzugsweise zwischen -20°C und 100°C eingesetzt. Die Messung der Halbleiter kann dabei im gesamten Temperaturbereich erfolgen. Die Erhitzungsphase dauert vorzugsweise zwischen 6 und 35 Stunden, vorzugsweise zwischen 8 und 30 Stunden und vorzugsweise zwischen 10 und 24 Stunden. Insgesamt können mit einem Testkontaktor etwa 10000 Tests durchgeführt werden. Während der Erhitzungsphase wird die Leiterplatte bzw. der Testkontaktor auf vorzugsweise 100°C bis 200°C und vorzugsweise auf ca. 125°C bis 150°C erhitzt.

Diese und andere Aufgaben, Merkmale und Vorteile der vorliegenden Erfindung werden aus dem Studium der folgenden detaillierten Beschreibung bevorzugter Ausführungsformen und der beiliegenden Zeichnungen deutlicher. Es ist ersichtlich, dass, obwohl Ausführungsformen separat beschrieben werden, einzelne Merkmale daraus zu zusätzlichen Ausführungsformen kombiniert werden können.
Fig. 1 zeigt eine Gehäuse-Bodenplatte des Testkontaktors;
Fig. 2 zeigt die Gehäuse-Bodenplatte aus Fig. 1 mit einem Basiselement, das an die Gehäuse-Bodenplatte geschraubt ist;
Fig. 3 zeigt die Elemente des Testkontaktors aus Fig. 2 mit eingesetzten Kontaktierungseinheiten;
Fig. 4 zeigt die Elemente des Testkontaktors aus Fig. 3 mit Abdeckplatten, die an dem Basiselement befestigt sind;
Fig. 5 zeigt die Elemente des Testkontaktors aus Fig. 4 mit eingesetzter Leiterplatte;
Fig. 6 zeigt einen Testkontaktor mit geöffnetem Gehäuse-Deckel
Fig. 7 zeigt einen geschlossenen Testkontaktor ohne Deckelelement;
Fig. 8 zeigt eine Seitenansicht eines Kraftführungselements
Fig. 9 zeigt einen geschlossenen Testkontaktor.

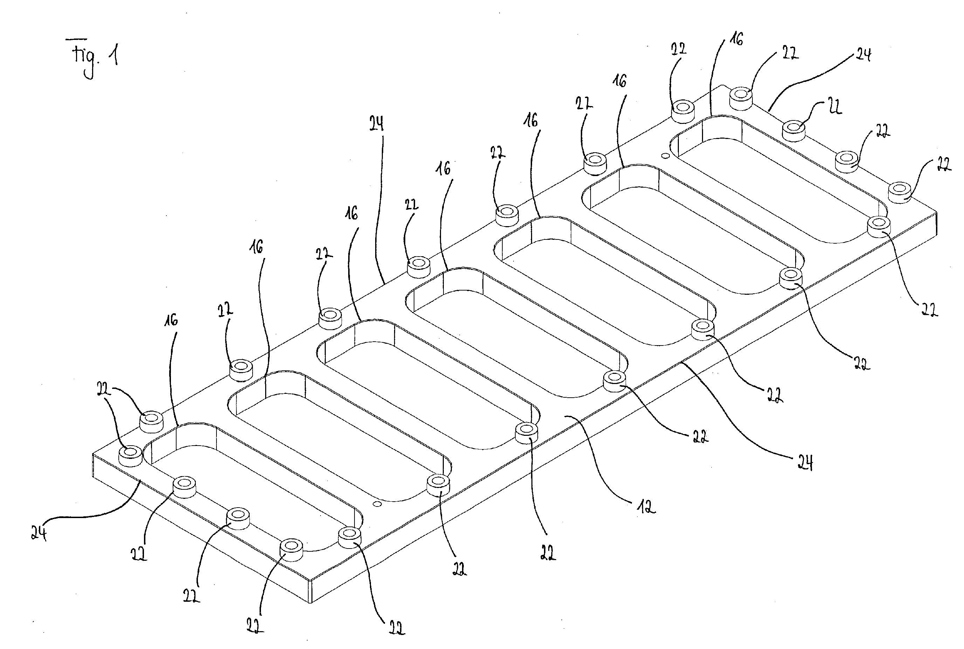

**Figur 1** zeigt einen Gehäuse-Bodenplatte 12 eines Gehäuses 14 für einen Testkontaktor 10 mit vorzugsweise einer Vielzahl von Bodenplatten-Öffnungen 16. Die Bodenplatten-Öffnungen 16 sind dabei derart angeordnet, dass später beschriebene Kontaktierungseinheiten 18, die in dem Testkontaktor 10 angeordnet sind, von einer Außenseite des Testkontaktors 10 zugänglich sind.

Auf der Gehäuse-Bodenplatte 12 ist ein Basiselement 20 (in Fig. 1 nicht gezeigt) angeordnet. Um eine verbesserte Wärmeausbreitung bzw. Ausbreitung warmer Luft in dem Testkontaktor 10 zu ermöglichen, ist jedoch vorzugsweise das Basiselement 20 nicht direkt auf der Gehäuse-Bodenplatte 12 angeordnet, sondern von dieser beabstandet. Dies kann, wie in Fig. 1 gezeigt, dadurch realisiert werden, dass zwischen der Gehäuse-Bodenplatte 12 und dem Basiselement 20 eine Vielzahl von Abstandshaltern 22 angeordnet ist. In dem in Fig. 1 gezeigten Fall ist die Vielzahl von Abstandshaltern 22 entlang der Außenkante 24 der Gehäuse-Bodenplatte 12 angeordnet. Die Abstandshalter 22 sind dabei als zylinderförmige Abstandshalter ausgebildet. Vorzugsweise weist das Basiselement 20 an der der Gehäuse-Bodenplatte 12 zugewandten Seite 26 Kerben (nicht gezeigt) auf, in denen die Abstandshalter 22 zumindest teilweise angeordnet sein können. Um die Abstandshalter 22 als auch das Basiselement 20 an der Gehäuse-Bodenplatte 12 zu fixieren, sind Basiselement-Fixierschrauben 28 durch entsprechende Bohrungen in dem Basiselement 20 und durch die Abstandshalter 22 hindurch in die Gehäuse-Bodenplatte 12 eingeschraubt.

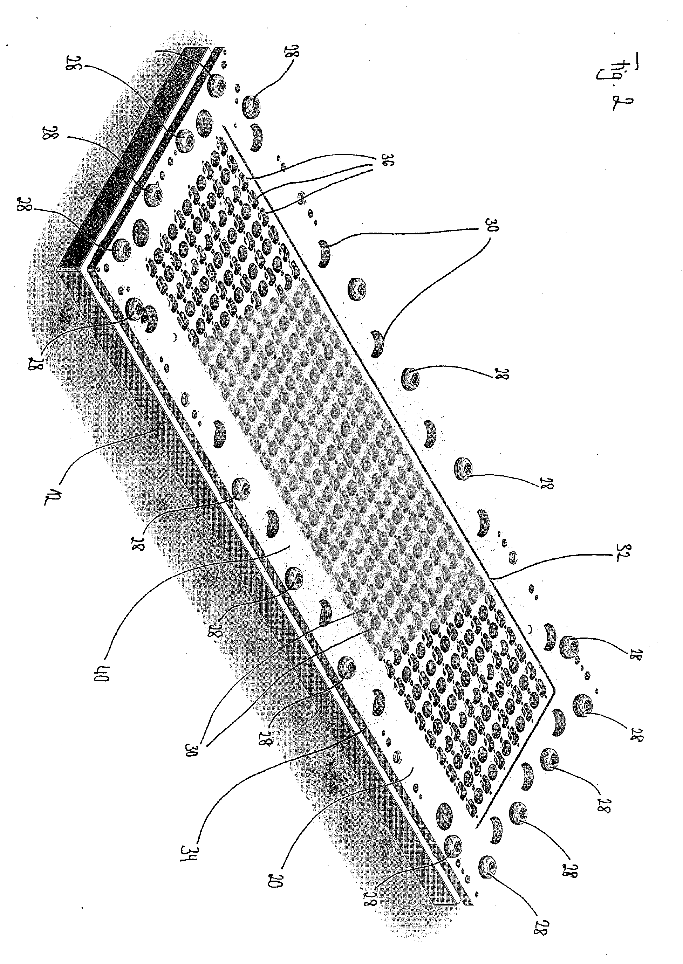

**Figur 2** zeigt die Gehäuse-Bodenplatte 12 mit dem Basiselement 20, das an der Gehäuse-Bodenplatte 12 angeordnet ist. Vorzugsweise, wie in Figur 2 gezeigt, ist das Basiselement 20 plattenförmig ausgebildet.

In einem Innenbereich 32 des Basiselements 20, der von der umlaufenden Außenkante 34 des Basiselements 20 beabstandet ist, ist eine Vielzahl von Basiselement-Öffnungen 36 ausgebildet. In jeder der Basiselement-Öffnungen 36 ist eine später näher beschriebene Kontaktierungseinheit 38 (nicht gezeigt in Figur 2) eingesetzt.

Vorzugsweise ist der Innenbereich 32 des Basiselements 20 im Verhältnis zu einem umlaufenden Basiselement-Randbereich 40 vertieft ausgebildet. Der Innenbereich 32 ist an der Seite des Basiselements 20, die von der Gehäuse-Bodenplatte 12 abgewandt ist, ausgebildet. Der Basiselement-Randbereich 40 erstreckt sich entlang der Außenkante 34 des Basiselements 20. In dem Basiselement-Randbereich 40 ist die Vielzahl von Basiselement-Fixierschrauben 28 eingeschraubt. In dem Basiselement-Randbereich 40 sowie in dem Innenbereich 32 sind vorzugsweise eine Vielzahl von Basiselement-Lüftungsöffnungen 30 ausgebildet, die zu einer verbesserten Wärmeausbreitung in dem Testkontaktor 10 beitragen.

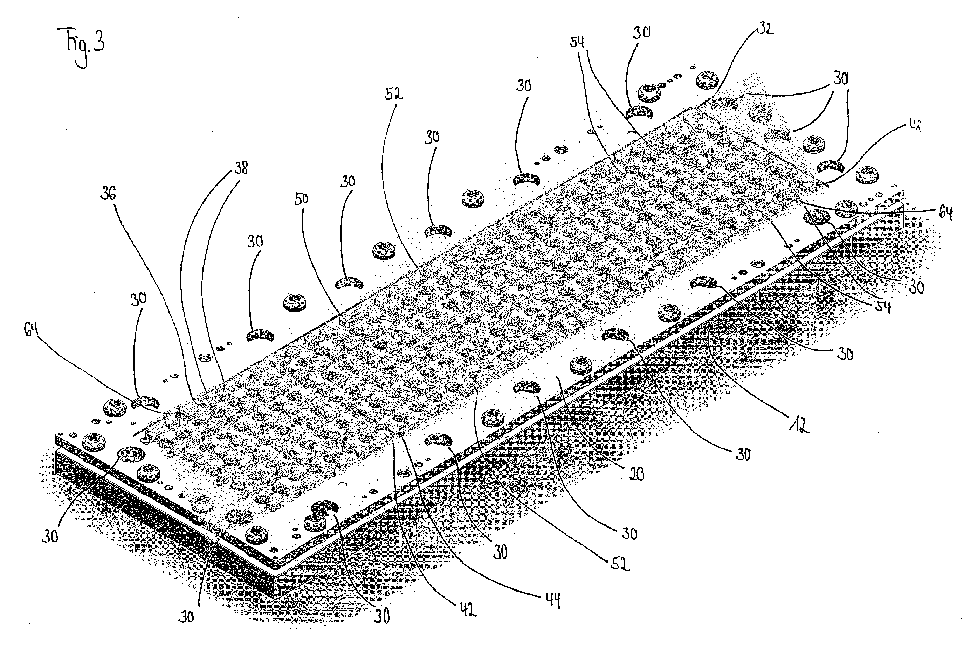

Wie in **Figur 3** gezeigt, ist jeweils eine Kontaktierungseinheit 38 in eine einzelne Basiselement-Öffnung 36 eingesetzt.

Jede Kontaktierungseinheit 38 weist einen Mittelbereich 42 und entgegengesetzte Endbereiche 44 auf. Der Mittelbereich 42 ist zwischen den Endbereichen 44 angeordnet und ist zumindest teilweise innerhalb der Basiselement-Öffnung 36 angeordnet. Um einen festen Sitz der Kontaktierungseinheit 38 innerhalb einer Basiselement-Öffnung 36 zu gewährleisten, entspricht die Außenfläche des Mittelbereichs 42 der Kontaktierungseinheit 38 der Form und Größe der Basiselement-Öffnung 36, so dass die Kontaktierungseinheit 38 in der Basiselement-Öffnung 36 ohne Verrutschen, im Wesentlichen ohne Spiel, gehalten werden kann.

Die Endbereiche 44 der Kontaktierungseinheit 38 sind an entgegengesetzten Enden des Mittelbereichs 42 angeordnet und ragen von entgegengesetzten Flächen des Basiselements 20 hervor.

Zur Kontaktierung von später beschriebenen Halbleiterelementen 46 (in Figur 3 nicht gezeigt), ist jeweils in den einzelnen Kontaktierungseinheiten 38 eine Vielzahl von Kontaktierungspins 48 eingesetzt. Hierzu sind in den Kontaktierungseinheiten 38 jeweils Kanäle 50 für die Kontaktierungspins 48 vorgesehen, die sich durch die Kontaktierungseinheit 38 hindurch erstrecken.

Um ein Einsetzen oder Wechseln der Kontaktierungspins 48 zu ermöglichen, sind die Kontaktierungseinheiten 38 vorzugsweise zweigeteilt. Bevorzugter Weise ist hierzu die Kontaktierungseinheit 38 in dem Mittelbereich 42 geteilt. Hierdurch wird ermöglicht, dass Kontaktierungspins 48, die stabförmig ausgebildet sind, in einem Mittelbereich (nicht gezeigt) einen größeren Durchmesser aufweisen können als in den Endbereichen der Kontaktierungspins 48. Eine derartige Form gewährleistet, dass ein Kontaktierungspin 48 nicht aus einer Kontaktierungseinheit 38 herausfallen kann. Mittels der zweigeteilten Kontaktierungseinheiten 38 sind derartig ausgeformte Kontaktierungspins 48 in einfacher Weise in die Kanäle 50 einsetzbar. Die Form und Größe der Kanäle 50 ist an die Kontaktierungspins 48 angepasst.

Die Anzahl der Kanäle 50 kann an die Anzahl der Kontaktierungspins 48 angepasst sein. Es ist jedoch ebenfalls möglich, dass, wie in Figur 3 gezeigt, mehr Kanäle 50 in den Kontaktierungseinheiten 38 vorgesehen sind als tatsächlich Kontaktierungspins 48 eingesetzt sind. Hierdurch wird ermöglicht, dass die Anzahl der Kontaktierungspins 48 an die Anzahl der Kontaktierungsarme der zu testenden Halbleiterelemente 46 angepasst werden kann.

Wie in Figur 3 gezeigt, ist der Umfang des Mittelbereichs 42 einer Kontaktierungseinheit 38 größer als der Umfang der Endbereiche 44 der Kontaktierungseinheit 38. Der hierdurch gebildete Sockel bietet die Möglichkeit, dass die Kontaktierungseinheit 38 an dem Basiselement 20 mittels einer Kontaktierungseinheit-Schraube 52 verschraubbar ist. Hierzu ist eine Kontaktierungseinheit-Schraube 52 in einem Randbereich um die Basiselement-Öffnung 36 eingeschraubt, wobei der Abstand zu der Basiselement-Öffnung 36 bzw. die Größe der Kontaktierungseinheit-Schraube 52 derart zu wählen ist, dass zumindest ein Teil des Kopfs der Kontaktierungseinheit-Schraube 52 den Sockel der Kontaktierungseinheit 38 überlappt. Vorzugsweise überlappt der Kopf einer Kontaktierungseinheit-Schraube 52 den Sockel mehrerer Kontaktierungseinheiten 38.

In dem Innenbereich 32 des Basiselements 20 ist weiterhin eine Vielzahl von Basiselement-Druckfedern 54 angeordnet, die vorzugsweise jeweils in entsprechenden Vertiefungen angeordnet sind. Die Basiselement-Druckfedern 54 können dabei vollständig in der Vertiefung angeordnet sein oder können über das Basiselement 20 hinaus ragen. Welche Alternative davon gewählt wird, hängt von der Konstruktion der später näher beschriebenen Abdeckplatten 56 ab, die an dem Basiselement 20 angeordnet sind. Im Speziellen hängt die zu wählende Alternative davon ab, ob Bereiche der Abdeckplatten 56, die mit den Basiselement-Druckfedern 54 in Kontakt treten, so ausgebildet sind, dass sie in die Vertiefungen für die Basiselement-Druckfedern 54 eindringen. Sollten die Abdeckplatten 56 derartige Bereiche nicht aufweisen, sind die Basiselement-Druckfedern 54 bzw. die entsprechenden Vertiefungen so zu wählen, dass die Basiselement-Druckfedern 54 über das Basiselement 20 hinaus ragen. Vorzugsweise weisen die Basiselement-Druckfedern 54 eine Federkonstante zwischen 0,05N/mm und 5N/mm und vorzugsweise zwischen 0,1 N/mm und 4Nmm. Vorzugsweise weisen die Basiselement-Druckfedern eine Federkonstante von 0,127N/mm oder 3N/mm auf.

Vorzugsweise sind an dem Basiselement 20 zwischen 10 und 100, vorzugsweise zwischen 20 und 80 und vorzugsweise zwischen 30 und 70 Druckfedern angeordnet.

Die Funktion der Basiselement-Druckfedern 54 wird später näher beschrieben.

Darüber hinaus ist an dem Basiselement 20, vorzugsweise in dem Innenbereich 32, eine Vielzahl von Positionierungspins 64 angeordnet, die an der den Abdeckplatten 56 zugewandten Seite des Basiselements 20 angeordnet ist. Diese sind derart lang gestaltet, dass diese die Abdeckplatten 56 durchdringen können und von den Abdeckplatten 56 hervorragen. Die einzusetzenden Leiterplatten weisen üblicherweise Leiterplatten-Öffnungen 66 auf, die als Referenzpunkte zur Positionsbestimmung der Halbleiterelemente auf der Leiterplatte ausgebildet sind. Im eingesetzten Zustand der Leiterplatte greifen die Positionierungspins 64 in die Leiterplatten-Öffnungen 66 ein.

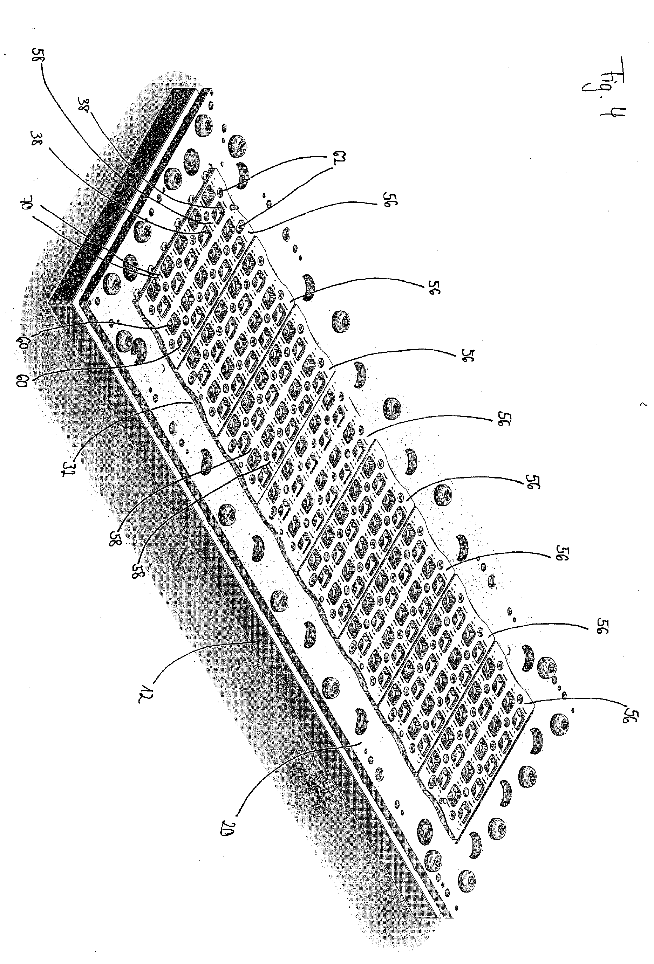

Wie in **Figur 4** gezeigt, ist an einer der Gehäuse-Bodenplatte 12 entgegengesetzten Seite des Basiselements 20 eine Vielzahl von Abdeckplatten 56 angeordnet, die vorzugsweise aus Kunststoff gefertigt ist. Die Vielzahl von Abdeckplatten 56 sind aneinander angrenzend angeordnet und weisen eine Gesamtgröße auf, die vorzugsweise dem Innenbereich 32 des Basiselements 20 entspricht. Insbesondere ist die Größe der Abdeckplatten 56 so gewählt, dass die Abdeckplatten 56 den Bereich des Basiselements 20 überlappen, in dem die Kontaktierungseinheiten 38 angeordnet sind.

Die Abdeckplatten 56 weisen eine Gitterstruktur mit einer Vielzahl von Gitterstreben 58 auf. Die sich aufgrund der Gitterstruktur zwischen den Gitterstreben 58 gebildeten Abdeckplatten-Öffnungen 60 sind vorzugsweise derart angeordnet, dass jeweils eine Abdeckplatten-Öffnung 60 eine Basiselement-Lüftungsöffnung 30 überlappt. Hierdurch wird eine vorteilhafte Wärmeausbreitung in dem Testkontaktor 10 ermöglicht.

Um die Abdeckplatten 56 an dem Basiselement 20 zu befestigen, ist eine Vielzahl von Abdeckplatten-Schrauben 62 in die Abdeckplatten eingeschraubt, die die Abdeckplatten 56 durchdringen und in das Basiselement 20 eingreifen.

Die Kontaktierungseinheiten 38 sind unter den Gitterstreben 58 angeordnet. Im Bereich der Kontaktierungseinheiten 38 sind an der dem Basiselement 20 zugewandten Seite der Abdeckplatten 56 Abdeckplatten-Vertiefungen 68 ausgebildet. In einer AbdeckplattenVertiefungen 68 ist zumindest bereichsweise eine Kontaktierungseinheit 38 aufgenommen. Vorzugsweise weist jede Abdeckplatten-Vertiefung 68 eine Größe und Form auf, die der Größe und Form eines Endbereichs 44 einer Kontaktierungseinheit 38 entspricht.

Weiterhin sind in jedem Bereich der Gitterstreben 58, der eine Kontaktierungseinheit 38 überlappt, Abdeckplatten-Pinöffnungen 70 vorgesehen. In jede der Abdeckplatten-Pinöffnungen 70 springt ein Kontaktierungspin 48 zumindest bereichsweise vor. Wie in Figur 4 gezeigt, ragen die Kontaktierungspins 48 nur geringfügig über die Abdeckplatten 56 hinaus. Vorzugsweise ragen die Kontaktierungspins 48 jedoch nicht über die Abdeckplatten 56 hinaus. Sind die Abdeckplatten 56 jedoch aufgrund einer später näher beschriebene rückstellfähigen Bewegung rückstellfähig verlagert, vergrößert sich der Teil der Kontaktierungspins 48, der über die Abdeckplatten 56 hinaus ragt, entsprechend. Ragen die Kontaktierungspins 48 in der ursprünglichen Position der Abdeckplatten 56 nicht über die Abdeckplatten 56 hinaus, ragen die Kontaktierungspins 48 von den Abdeckplatten 56 hervor, wenn die Abdeckplatten 56 rückstellfähig verlagert sind.

Wie bereits bezüglich der Anzahl der Kanäle 50 der Kontaktierungseinheiten 38 beschrieben, kann die Anzahl der Abdeckplatten-Pinöffnungen 70 größer sein als die Anzahl der tatsächlich vorhandenen Kontaktierungspins 48, so dass die Abdeckplatten 56 für verschiedene Kontaktierungseinheiten verwendet werden können.

Obwohl Figur 4 eine Vielzahl von Abdeckplatten 56 zeigt, ist es ebenfalls möglich, dass nur eine Abdeckplatte 56 vorgesehen ist.

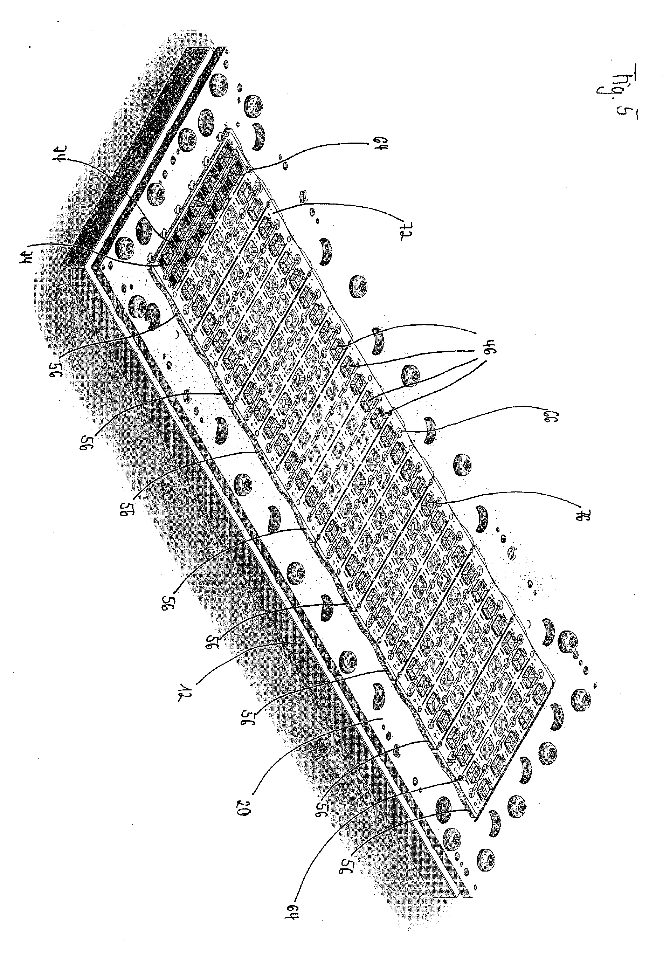

**Figur 5** zeigt die bisher beschriebenen Komponenten des Testkontaktors 10, in den eine Leiterplatte 72, auf der eine Vielzahl von Halbleiterelementen 46 angeordnet ist, eingesetzt ist.

Wie bereits oben beschrieben wurde, weist die Leiterplatte 72 eine Vielzahl von Leiterplatten-Öffnungen 66 auf. In jede Leiterplatten-Öffnung 66 greift ein Positionierungspin 64 ein, um die Position der Leiterplatte 72 zu fixieren.

Die Halbleiterelemente 46 sind dabei so positioniert, dass ein Halbleitergehäuse 76 jeweils über einer entsprechenden Abdeckplatten-Öffnung 60 angeordnet ist. Die Kontaktierungsarme bzw. Kontakierungsbonds 74 der Halbleiterelemente 46, die von entgegengesetzten Seiten eines Halbleitergehäuses 76 hervorragen, liegen auf Gitterstreben 58 auf. Insbesondere überlappt jeder Kontaktierungsarm 74 einen Bereich einer Gitterstrebe, in dem ein Kontaktierungspin 48 angeordnet ist, um von diesem kontaktiert zu werden.

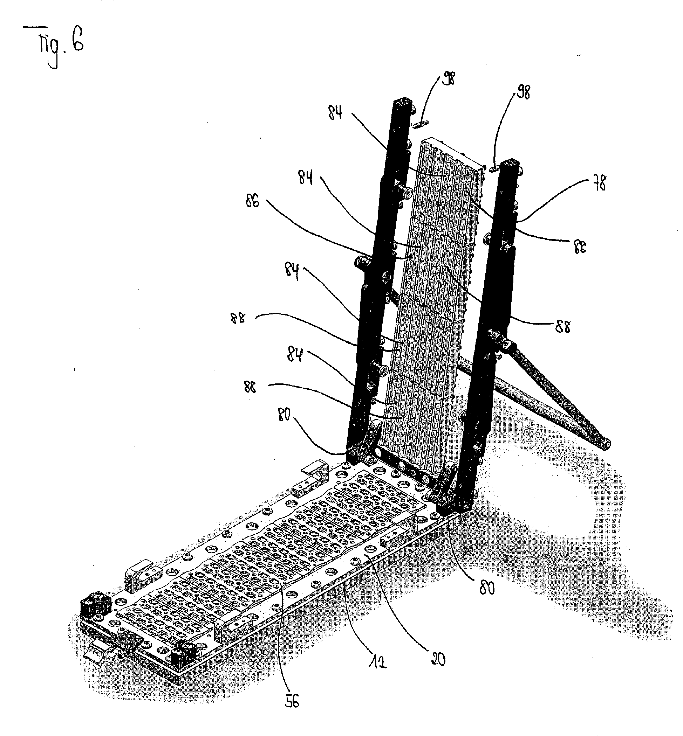

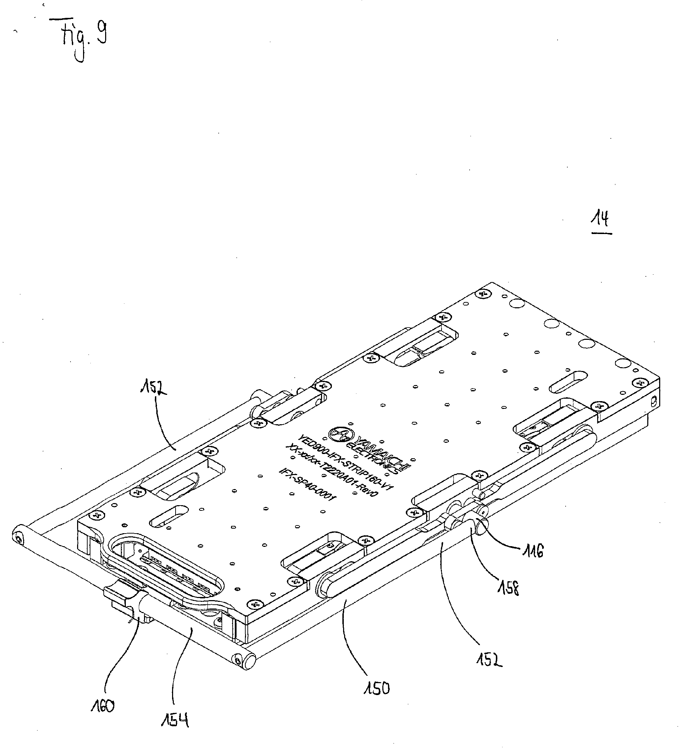

Um eine rückstellfähige Bewegung der Abdeckplatten 56 zusammen mit der Leiterplatte 72 zu erzielen, weist der Testkontaktor 10 einen Gehäuse-Deckel 78 auf, der vorzugsweise an dem Basiselement 20 mittels eines später näher beschriebenen Scharniers 80 befestigt ist. Der Gehäuse-Deckel 78 ist hierdurch zwischen einer offenen Position, wie in **Figur 6** gezeigt ist, und einer geschlossenen Position, wie in **Figur 9** gezeigt, verschwenkbar.

In einer offenen Position des Gehäuses 14 können Leiterplatten eingesetzt bzw. ausgetauscht werden. In einer geschlossenen Position drückt der Gehäuse-Deckel 78 auf die Leiterplatte 72 und/oder die Abdeckplatten 56, um diese rückstellfähig in eine Richtung zu dem Basiselement 20 zu bewegen und um die notwendige Kontaktierungskraft zu erzeugen, die benötigt wird, um die Kontaktierungsarme 74 der Halbleiterelemente 46 mittels der Kontaktierungspins 48 zu kontaktieren.

Vorzugsweise sind die Leiterplatte 71 bzw. die Abdeckplatten 56 mit einer Kraft zwischen 490 und 1970 N, vorzugsweise zwischen 670 und 1470 N und vorzugsweise zwischen 700 und 1100 N beaufschlagt, die der Gehäuse-Deckel 78 auf die Leiterplatte 71 bzw. die Abdeckplatten 56 aufbringt. Bevorzugterweise ist die Kraft etwa 700N.

Der Gehäuse-Deckel 78 weist ein Deckelelement 82 (in Figur 6 nicht gezeigt) auf, dass im geschlossenen Zustand des Gehäuses 14 vorzugsweise parallel zu den Abdeckplatten 56 bzw. der Leiterplatte 72 ausgerichtet ist.

Um Unebenheiten und Fertigungstoleranzen der Leiterplatte 72 auszugleichen und einen gleichmäßigen Druck bzw. eine gleichmäßige Kraft auf die Leiterplatte 72 und die Abdeckplatten 56 aufzubringen, weist der Gehäuse-Deckel 78 eine Vielzahl von Anpresselementen 84 auf. Die Anpresselemente 84 sind an einer den Abdeckplatten 56 zugewandten Seite des Gehäuseelements 82 angeordnet und sind vorzugsweise rechteckig ausgebildet.

Die Anpresselemente 84 sind aneinander angrenzend angeordnet und sind an dem Deckelelement 82 mittels Anpresselement-Schrauben 86 festgeschraubt. Die Größe und Position der Anpresselemente 84 sind so gewählt, dass sich die Anpresselemente 84 über die gesamte Fläche der Leiterplatte 72 und/oder der Abdeckplatten 56 erstrecken.

Um in verbesserter Weise eine gleichmäßigen Druck bzw. Kraft auf die Leiterplatte 72 und die Abdeckplatten 56 aufzubringen, sind vorzugsweise eine Vielzahl von Druckfedern (nicht gezeigt) zwischen dem Deckelelement 82 und den Anpresselementen 84 angeordnet.

An der den Abdeckplatten 56 bzw. der Leiterplatte 72 zugewandten Seite der Anpresselemente 84 sind vorzugsweise eine Vielzahl von Anpresselement-Aussparungen 88 ausgebildet, in denen die Halbleitergehäuse 76 zumindest teilweise angeordnet sind, wenn das Gehäuse 14 geschlossen ist. Es kann dabei für jedes Halbleitergehäuse 76 eine Anpresselement-Aussparung 88 vorgesehen sein oder eine Anpresselement-Aussparung 88 für eine Vielzahl von Halbleitergehäuse 76.

Obwohl Figur 6 eine Vielzahl von Anpresselementen 84 zeigt, kann auch nur ein Anpresselement 84 in dem Testkontaktor 10 vorhanden sein. Bei einem Anpresselement 84 ist die Größe des einzelnen Anpresselements 84 so gewählt, dass dieses vorzugsweise die gesamte eingesetzte Leiterplatte überdeckt.

Der Gehäuse-Deckel 78 weist zwei Seitenwände 90 auf, die parallel zueinander und voneinander beabstandet angeordnet sind. Der Abstand der Seitenwände 90 entspricht vorzugsweise der Testkontaktorgröße.

Flächen der beiden Seitenwände 90, die sich gegenüber liegen, werden als "Innenflächen" bezeichnet. Flächen der beiden Seitenwände 90, die parallel zu den Innenflächen ausgebildet sind, jedoch voneinander abgewandt sind, werden als "Außenflächen" bezeichnet.

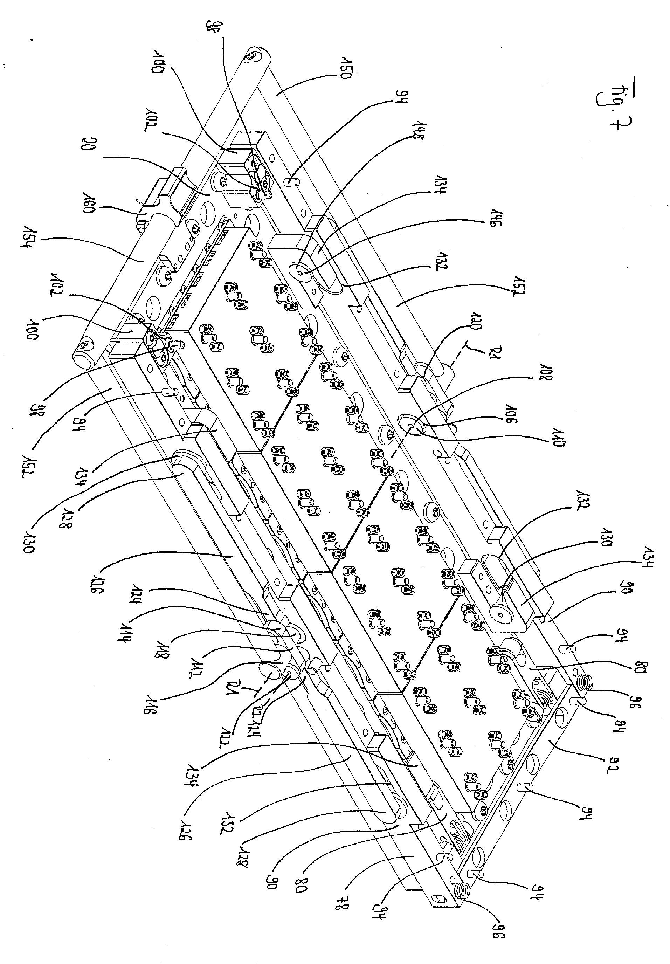

An zumindest einem Ende der Seitenwände 90 sind die beiden Seitenwände 90 mittels einer Deckelstrebe 92 verbunden, wie in **Figur 7** gezeigt. Auf die Seitenwände 90 und auf die Deckelstrebe 92 ist das Deckelelement 82 (in Figur 7 nicht gezeigt) mittels Deckelelement-Stifte 94 aufgesetzt. Die Deckelelement-Stifte 94 greifen in die Deckelstrebe 92 und in das Deckelelement 82 ein. Um eine federnde Lagerung des Deckelements 82 zu ermöglichen, ist vorzugsweise zumindest eine Druckfeder 96 zwischen jeder Seitenwand 90 und dem Deckelelement 82 angeordnet. Vorzugsweise ist jede Druckfeder 96 in einem Bereich angeordnet, in dem die Deckelstrebe 92 die beiden Seitenwände 90 verbindet.

Das Scharnier 80 umfasst zumindest zwei Scharnierelemente, die an dem Basiselement 20 und an der Deckelstrebe 92 befestigt sind. Vorzugsweise sind die Scharnierelemente federnd gelagert. Das Ende des Testkontaktors 10, an dem das Scharnier 80 angeordnet ist, wird als ein "hinteres Ende" bezeichnet. In Folge dessen wird das gegenüber liegende Ende des Testkontaktors 10 als "vorderes Ende" bezeichnet.

Die Richtungsangaben "vorne" und "hinten" beziehen sich auch entsprechend auf alle Bauteile des Testkontaktors 10.

An einem vorderen Ende des Deckelelements 82 ist vorzugsweise an Positionen nahe bzw. angrenzend an die Innenfläche der Seitenwände 90 jeweils ein Führungspin 98 angeordnet. Jeder Führungspin 98 ist an dem Deckelement 82 befestigt und erstreckt sich im geschlossenen Zustand des Gehäuses 14 in Richtung zu dem Basiselement 20.

An dem Basiselement 20 sind auf einer im geschlossenen Zustand des Gehäuses 14 dem Deckelelement 82 zugewandten Seite Führungsvorrichtungen 100 angeordnet. Jede Führungsvorrichtung 100 ist vorzugsweise mittels Schrauben an dem Basiselement 20 befestigt. Jede der Führungsvorrichtungen 100 weist einen Führungskanal 102 auf, in den ein entsprechender Führungspin 98 eintreten kann und während des Schließvorgangs des Gehäuse-Deckels führbar ist, so dass ein Verkanten des Gehäuse-Deckels 78 während des Schließvorgangs vermieden werden kann. Darüber hinaus wird die Position des Gehäuse-Deckels 78 im geschlossenen Zustand fixiert und ein Verrutschen des Gehäuse-Deckels 78 vermieden.

Um einen kontrollierten Schließvorgang des Gehäuse-Deckels 78 zu gewährleisten, weist der Gehäuse-Deckel 78 eine Hebelvorrichtung 104 auf, die an dem Gehäuse-Deckel 78 befestigt ist.

Hierzu weist jede Seitenwand 90 eine Lagerbohrung 106 auf, die sich in einer Richtung parallel zu dem Basiselement 20 durch die Seitenwände 90 erstreckt. Mit anderen Worten erstreckt sich die Lagerbohrung 106 senkrecht zu der Innenfläche und Außenfläche der der Seitenwand 90.

In jede Lagerbohrung 106 ist ein Lagerbolzen 108 eingesetzt. Ein Lagerbolzenkopf 110 jedes Lagerbolzens 108 ist an der Innenfläche der Seitenwand 90 angeordnet. Mit Hilfe der Lagerbolzen 108 wird jeweils ein Rotationselement 112 an den Seitenwänden 90 befestigt und drehbar um eine Rotationsachse R1 gelagert. Die Rotationsachse R1 ist senkrecht zu der Innenfläche und der Außenfläche der Seitenwand 90 ausgerichtet. Jedes Rotationselement 112 ist auf der Außenfläche der Seitenwände 90 angeordnet.

Das Rotationselement 112 weist eine Rotationselement-Platte 114 und einen ersten und zweiten Rotationselement-Vorsprung 116, 118 auf. Die Rotationselement-Platte 114 ist parallel zu der entsprechenden Seitenwand 90, an der das Rotationselement 112 befestigt ist, ausgerichtet. Weiterhin weist die Rotationselement-Platte 114 vorzugsweise eine rechteckige Form auf. Die ersten und zweiten Rotationselement-Vorsprünge 116, 118 sind an der Rotationselement-Platte 114 an entgegengesetzten Seiten der Rotationselement-Platte 114 angeordnet und ragen von der Rotationselement-Platte 114 entlang der Rotationsachse R1 des Rotationselements 112 vor.

Der zweite Rotationselement-Vorsprung 118 ist zwischen der Seitenwand 90 und der Rotationselement-Platte 114 angeordnet, während der erste Rotationselement-Vorsprung 116 von der Rotationselement-Platte 114 in eine Richtung von der Seitenwand 90 weg, an der das Rotationselement 112 befestigt ist, vorspringt.

An entgegengesetzten Enden der Rotationselement-Platte 114 ist jeweils eine Rotationselement-Bohrung 120 ausgebildet, so dass eine jeweilige Rotationsachse R2 der Rotationselement-Bohrungen 120 parallel zu der Rotationsachse R1 des Rotationselements 112 ausgerichtet ist. Wird das Rotationselement 112 gedreht, verändert sich die Position der Rotationsachse R1 des Rotationselements 112 nicht, während die Rotationsachsen R2 der Rotationselement-Bohrungen 120 entlang einer Kreisbahn um die Rotationsache R1 des Rotationselements 112 verschoben werden.

Mit Hilfe von Lagerbolzen 122, die jeweils in die Verbindungselement-Bohrungen 120 eingesetzt sind, wird jeweils ein erstes Ende 124 eines Lagerelement-Verschiebearms 126 drehbar an dem Rotationselement 112 befestigt. Vorteilhafterweise ist der Lagerelement-Verschiebearm 126 stabförmig ausgebildet.

Das jeweils zweite Ende 128 des Lagerelement-Verschiebearms 126 ist mit einem Lagerelement 130 verbunden, das sich zu der Seitenwand 90 hin erstreckt. Insbesondere erstreckt sich das Lagerelement 130 durch die Seitenwand 90 hindurch. Hierzu ist in jeder Seitenwand 90 in einem Bereich vor und einem Bereich hinter des Rotationselements 112 je eine Seitenwand-Öffnung 132 vorhanden, durch die sich jeweils ein Lagerelement 130 hindurch erstreckt. Die Seitenwand-Öffnung 132 ist in Form eines Langlochs ausgebildet, in dem das Lagerelement 130 in einer Richtung zu und weg von der Rotationsachse R1 des Verbindungselements 112 verschiebbar ist. Im Speziellen ist jede Seitenwand-Öffnung 132 als Langloch ausgebildet, das sich in einer Längsrichtung des Testkontaktors 10 erstreckt. Als Längsrichtung wird die Richtung verstanden, die sich von einem hinteren Ende zu einem vorderen Ende des Testkontaktors 10 erstreckt. Durch ein Verschieben des Lagerelements 130 in einer Seitenwand-Öffnung 132 führt das Lagerelement eine lineare Bewegung in einer Längsrichtung aus. Die Bewegung des Lagerelements 130 innerhalb der Seitenwand-Öffnung 132 wird durch eine Drehbewegung des Rotationselements 112 ausgelöst.

An dem Basiselement 20 ist eine Vielzahl von Kraftführungselementen 134 befestigt, die sich im geschlossenen Zustand des Gehäuses 14 von dem Basiselement 20 in Richtung zu dem Deckelement 82 hin erstrecken. Je ein Kraftführungselement 134 ist an einer Innenseite der Seitenwände 90 in einem Bereich angeordnet, der eine Seitenwand-Öffnung 132 überlappt. Mit anderen Worten weist der Testkontaktor 10 vier Kraftführungselemente 134 auf.

In jedem der Kraftführungselemente 134 ist eine Nockenlaufbahn 136 ausgebildet, in die jeweils eines der oben beschriebenen Lagerelemente 130 eingreift und in dieser verschiebbar gelagert ist. Die Nockenlaufbahn 136 weist jeweils ein erstes offenes Ende 138 und ein zweites geschlossenes Ende 140 auf, wobei das offene Ende 138 jeder Nockenlaufbahn 136 näher an dem jeweiligen Rotationselement 112 angeordnet ist als das geschlossene Ende 140.

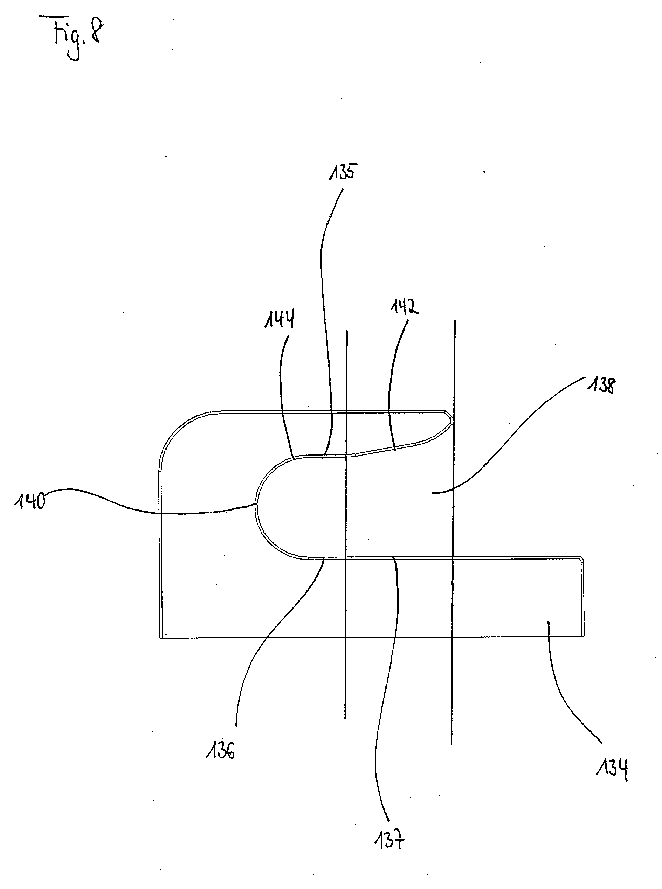

Wie in **Figur 8** gezeigt, weist jede der Nockenlaufbahnen 136 einen Steigungsbereich 142 und einen steigungsfreien Bereich 144 auf. Der Steigungsbereich 142 zwischen dem steigungsfreien Bereich 144 und dem offenen Ende 138 angeordnet ist. Der steigungsfreie Bereich 144 ist zwischen dem Steigungsbereich 142 und dem geschlossenen Ende 140 angeordnet.

Die Nockenlaufbahn 136 weist eine obere Laufbahn 135 und eine untere Laufbahn 137 auf. Die untere Laufbahn 137 ist die Laufbahn, die näher an dem Basiselement 20 ausgebildet ist, während die obere Laufbahn 135 die Laufbahn ist, die im geschlossenen Zustand des Gehäuses 14 näher an dem Deckelelement 82 ist.

In dem Steigungsbereich 142 nimmt die Steigung von dem offenen Ende 138 zu dem steigungsfreien Bereich 144 hin ab. Dies wird erzielt, in dem der Abstand der oberen Laufbahn 135 von der unteren Laufbahn 137 abnimmt. Vorzugsweise ist der Abstand zwischen der oberen Laufbahn 135 und der unteren Laufbahn 137 in dem Steigungsbereich am offenen Ende 138 zwischen 10mm und 18mm, vorzugsweise zwischen 12mm und 16mm und vorzugsweise zwischen 14mm und 15mm. Vorzugsweise ist der Abstand zwischen der oberen Laufbahn 135 und der unteren Laufbahn 137 in dem Steigungsbereich am offenen Ende 138 10,4mm oder 11,12mm. Der Abstand zwischen der oberen Laufbahn 135 und der unteren Laufbahn 137 nimmt bis zum steigungsfreien Bereich 144 ab, wo er dann vorzugsweise zwischen 4mm und 12mm, vorzugsweise zwischen 6mm und 10mm und vorzugsweise zwischen 8 und 9 mm beträgt. Vorzugsweise ist der Abstand zwischen der oberen Laufbahn 135 und der unteren Laufbahn 137 dort 8,4mm. Ist der Abstand zwischen der oberen Laufbahn 135 und der unteren Laufbahn 137 in dem Steigungsbereich am offenen Ende 138 11,12mm und an der Grenze zu dem steigungsfreien Bereich 144 8,4mm, verringert sich somit der Abstand um 2,72mm. Die Länge der oberen Laufbahn 135 in dem Steigungsbereich 142 beträgt vorzugsweise zwischen 1 mm und 10mm, vorzugsweise zwischen 2mm und 8mm und vorzugsweise 2,72mm. Wie in Figur 8 gezeigt, ist hierzu die obere Laufbahn 135 schräg zu der unteren Laufbahn 137 ausgerichtet. Vorzugsweise erstreckt sich die untere Laufbahn 137 parallel zu dem Basiselement 20.

In dem steigungsfreien Bereich 144 weist die Nockenlaufbahn 136 keine Steigung auf. Hierzu verändert sich der Abstand zwischen der oberen Laufbahn 135 und der unteren Laufbahn 137 in dem steigungsfreien Bereich 144 nicht. Mit anderen Worten sind die oberen Laufbahn 135 und die untere Laufbahn 137 in dem steigungsfreien Bereich 144 im Wesentlichen parallel zueinander ausgerichtet. Vorzugsweise verlaufen die oberen Laufbahn 135 und die untere Laufbahn 137 parallel zu dem Basiselement 20.

Mit Hilfe eines Lagerelement-Bolzens 146 ist das Lagerelement 130 an dem entsprechenden Lagerelement-Verschiebearm 126 befestigt. Der Kopf 148 des Lagerelement-Bolzens 146 ist an einer Seite des Kraftführungselements 134 angeordnet, die der Seitenwand 90 abgewandt ist. Der Kopf 148 des Lagerelement-Bolzens 146 kann hierdurch als Begrenzungselement genutzt werden, um eine zuverlässige Führung des Lagerelements 130 in der Nockenlaufbahn 136 zu gewährleisten.

Vorteilhafterweise kontaktieren sich die Kraftführungselemente 134 und die jeweilige Seitenwand 90, an der die Kraftführungselemente 134 jeweils angeordnet sind, so dass die Lagerelemente 130 so kurz wie möglich gestaltet werden können.

In einer bevorzugten Ausführungsform weist das Lagerelement 130 einen ersten Lagerelement-Teil und einen zweiten Lagerelement-Teil auf. Der erste Lagerelement-Teil des Lagerelements 130 ist in dem Bereich der Seitenwand-Öffnung 132 angeordnet. Der zweite Lagerelement-Teil des Lagerelements 130 ist im geschlossenen Zustand des Gehäuses 14 in der Nockenlaufbahn 136 angeordnet ist, um in dieser geführt zu werden.

In einem Schließvorgang des Gehäuse-Deckels 78 werden zunächst die Lagerelemente 130 in die jeweiligen Nockenlaufbahnen 136 über die offenen Enden 138 der Nockenlaufbahn 136 eingesetzt. Mit Hilfe eines Hebels 150, der an den Rotationselementen 112 befestigt ist, kann dann das Lagerelement 130 in der Nockenlaufbahn 136 zu dem geschlossenen Ende 140 der Nockenlaufbahn 136 verschoben werden. Hierzu wird der Hebel 150 verschwenkt, wodurch die Rotationselemente 112 eine Rotationsbewegung um die Rotationsachse R1 durchführen. Aufgrund der Rotationsbewegung der Rotationselemente 112 verschieben sich die Rotationsachsen R2, wodurch die Lagerelement-Verschiebearme 126 in Längsrichtung verschoben werden. Insbesondere werden die Lagerelemente 130, die in einer Seitenwand 90 angeordnet sind, durch das Verschwenken des Hebels 150 weiter auseinander geschoben.

Im Speziellen weist der Hebel 150 zwei Hebelarme 152 aufweist, die parallel voneinander beabstandet angeordnet sind und deren erste Enden 156 mittels eines Griffelements 154 verbunden sind. Die zweiten Enden 158 der Hebelarme 152 sind jeweils mit einem der ersten Rotationselement-Vorsprünge 116 fest verbunden. Beispielsweise werden die Hebelarme 152 mit den ersten Verbindungselement-Vorsprüngen 116 verschraubt. Die Hebelarme 152 können jedoch auch integral mit den Rotationselementen 112 ausgebildet sein.

Vorzugsweise ist der Hebel 150 um 180° verschwenkbar an dem Gehäuse-Deckel 78 angeordnet.

Sobald die Lagerelemente 130 in die Nockenlaufbahnen 136 eingesetzt wurden, wird der Hebel 150 von einer hinteren Seite zu einer vorderen Seite verschwenkt bis sich die Hebelarme 152 in Längsrichtung erstrecken. In dieser Endposition des Hebels 150 erreichen die Lagerelemente 130 das geschlossene Ende 140 der Nockenlaufbahn 136, wodurch eine Selbsthemmung erzielt wird.

Durch die Führung der Lagerelemente 130 entlang des Steigungsbereichs 142 wird der Gehäuse-Deckel 78 zu dem Basiselement 20 in kontrollierter Weise hingezogen. Mit Hilfe der Länge und der Steigung des Steigungsbereichs 142 kann die Kraft definiert werden, mit der der Gehäuse-Deckel 78 bzw. die Anpresselemente 84 auf die Abdeckplatten 56 bzw. die Leiterplatte 72 pressen. Die notwendige Kraft ist die Kraft, die dazu notwendig ist, die Abdeckplatten 56 rückstellfähig zu bewegen und die Kontaktierungsarme bzw. Kontaktierungsbonds 74 der Halbleiterelemente 46 mittels der Kontaktierungspins 48 zu kontaktieren.

Um den Hebel 150 in der Endposition zu fixieren, ist an dem Basiselement 20 zumindest ein Fangarm 160 angeordnet, der von dem Basiselement 20 über die Außenkante des Basiselements 20 hinausragt. Sobald der Hebel 150 vollständig in seine Endposition verschwenkt wurde, rastet das Griffelement 154 in den Fangarm 160 ein (siehe **Figur 9**). Somit kann ein ungewolltes weiteres Verschwenken des Hebels 150 vermieden werden.

### Bezugszeichenliste

- 10: Testkontaktor
- 12: Gehäuse-Bodenplatte
- 14: Gehäuse
- 16: Bodenplatten-Öffnung
- 18: Kontaktierungseinheit
- 20: Basiselement
- 22: Abstandshalter
- 24: Außenkante der Gehäuse-Bodenplatte
- 26: der Gehäuse-Bodenplatte zugewandte Seite des Basiselements
- 28: Basiselement-Fixierschraube
- 30: Basiselement-Lüftungsöffnung
- 32: Innenbereich
- 34: Außenkante des Basiselements
- 36: Basiselement-Öffnung
- 38: Kontaktierungseinheit
- 40: Basiselement-Randbereich
- 42: Mittelbereich der Kontaktierungseinheit
- 44: Endbereich der Kontaktierungseinheit
- 46: Halbleiterelement
- 48: Kontaktierungspin
- 50: Kanal
- 52: Kontaktierungseinheit-Schraube
- 54: Basiselement-Druckfeder
- 56: Abdeckplatte
- 58: Gitterstrebe
- 60: Abdeckplatten-Öffnung
- 62: Abdeckplatten-Schraube
- 64: Positionierungspin
- 66: Leiterplatten-Öffnung
- 68: Abdeckplatten-Vertiefung
- 70: Abdeckplatten-Pinöffnung
- 72: Leiterplatte
- 74: Kontaktierungsarm des Halbleiterelements
- 76: Halbleitergehäuse
- 78: Gehäuse-Deckel
- 80: Scharnier
- 82: Deckelelement
- 84: Anpresselement
- 86: Anpresselement-Schraube
- 88: Anpresselement-Aussparung
- 90: Seitenwand
- 92: Deckelstrebe
- 94: Deckelelement-Stift
- 96: Druckfeder
- 98: Führungspin
- 100: Führungsvorrichtung
- 102: Führungskanal
- 104: Hebelvorrichtung
- 106: Lagerbohrung
- 108: Lagerbolzen
- 110: Lagerbolzenkopf
- 112: Rotationselement
- 114: Rotationselement-Platte
- 116: erster Rotationselement-Vorsprung
- 118: zweiter Rotationselement-Vorsprung
- 120: Rotationselement-Bohrung
- 122: Lagerbolzen
- 124: erstes Ende des Lagerelement-Verschiebearms
- 126: Lagerelement-Verschiebearm
- 128: zweites Ende des Lagerelement-Verschiebearms
- 130: Lagerelement
- 132: Seitenwand-Öffnung
- 134: Kraftführungselement
- 136: Nockenlaufbahn
- 138: offenes Ende der Nockenlaufbahn
- 140: geschlossenes Ende der Nockenlaufbahn
- 142: Steigungsbereich
- 144: steigungsfreier Bereich
- 146: Lagerelement-Bolzen
- 148: Kopf des Lagerelement-Bolzens
- 150: Hebel
- 152: Hebelarm
- 154: Griffelement
- 156: erstes Ende des Hebelarms
- 158: zweites Ende des Hebelarms
- 160: Fangarm

- R1: Rotationsachse des Rotationselements
- R2: Rotationsachse der Rotationselement-Bohrung

## Patentansprüche

1. Testkontaktor (10) zum Kontaktieren von Halbleiterelementen (46), umfassend:
ein Gehäuse (14) mit einer Gehäuse-Bodenplatte (12) und einem Gehäuse-Deckel (78) zum Öffnen des Gehäuses (14);
ein Basiselement (20), welches an der Gehäuse-Bodenplatte (12) angeordnet ist;
eine Vielzahl von Kontaktierungseinheiten (38) mit jeweils zumindest einem Kontaktierungspin (48), wobei jede Kontaktierungseinheit (38) an dem Basiselement (20) angeordnet ist;
zumindest eine Abdeckplatte (56), welche rückstellfähig an dem Basiselement (20) angeordnet ist und eine Vielzahl von Abdeckplatten-Pinöffnungen (70) aufweist, wobei sich ein Kontaktierungspin (48) zumindest bereichsweise in eine zugeordnete Abdeckplatten-Pinöffnung (70) erstreckt; und
zumindest ein Anpresselement (84), welches im geschlossenen Zustand des Gehäuses (14) an einer der zumindest einen Abdeckplatte (56) zugewandten Seite des Gehäuse-Deckels (78) angeordnet ist,
wobei das zumindest eine Anpresselement (84) im geschlossenen Zustand des Gehäuses (14) gegenüber der zumindest einen Abdeckplatte (56) angeordnet ist, und
wobei im geschlossenen Zustand des Gehäuses (14) zumindest bereichsweise ein Zwischenraum zwischen der zumindest einen Abdeckplatte (56) und einer der zumindest einen Abdeckplatte (56) zugewandten Seite des Anpresselements (84) ausbildet ist, wobei in den Zwischenraum zumindest bereichsweise Halbleiterelemente (46) einsetzbar sind, so dass die Halbleiterelemente (46) von Kontaktierungspins (48) kontaktierbar sind.

2. Testkontaktor (10) gemäß Anspruch 1, wobei das Basiselement (20) eine Vielzahl von Basiselement-Öffnungen (36) aufweist, wobei in jeder der Basiselement-Öffnungen (36) eine Kontaktierungseinheit (38) angeordnet ist.

3. Testkontaktor (10) gemäß Anspruch 2, wobei die Form und Größe einer Basiselement-Öffnung (36) einem Bereich der Außenflächenform der Kontaktierungseinheit (38) entspricht, die in der Basiselement-Öffnung (36) angeordnet ist.

4. Testkontaktor (10) gemäß einem der vorangehenden Ansprüche, wobei die zumindest eine Abdeckplatte (56) eine Gitterstruktur aufweist.

5. Testkontaktor (10) gemäß Anspruch 4, wobei die Gitterstruktur Gitterstreben (58) umfasst, in denen die Vielzahl von Abdeckplatten-Pinöffnungen (70) angeordnet sind und
wobei an einer dem Basiselement (20) zugewandten Seite der Gitterstreben (58) zumindest in Bereichen, in denen die Abdeckplatten-Pinöffnungen (70) angeordnet sind, zumindest eine Abdeckplatten-Vertiefung (68) ausgebildet ist, in die die Kontaktierungseinheiten (38) hineinragen.

6. Testkontaktor (10) gemäß einem der vorangehenden Ansprüche, wobei im geschlossenen Zustand des Gehäuses (14) das zumindest eine Anpresselement (84) an der der zumindest einen Abdeckplatte (56) zugewandten Seite zumindest eine Anpresselement-Aussparung (88) aufweist, die derart ausgelegt ist, dass Halbleiterelemente (46) darin aufnehmbar sind.

7. Testkontaktor (10) gemäß einem der vorangehenden Ansprüche, wobei die Gehäuse-Bodenplatte (12) zumindest eine Bodenplatten-Öffnung (16) aufweist, die derart angeordnet ist, dass die Kontaktierungseinheiten (38) durch eine externe Ausleseeinheit kontaktierbar sind.

8. Testkontaktor (10) gemäß einem der vorangehenden Ansprüche, wobei das Basiselement (20) von der Gehäuse-Bodenplatte (12) mittels zumindest einem Abstandshalter (22) beabstandet ist.

9. Testkontaktor (10) gemäß einem der vorangehenden Ansprüche, wobei das zumindest eine Anpresselement (84) rückstellfähig an dem Gehäuse-Deckel (78) gelagert ist.

10. Testkontaktor (10) gemäß einem der vorangehenden Ansprüche, wobei zumindest ein Positionierungspin (64) an einer der zumindest einen Abdeckplatte (56) zugewandten Seite des Basiselements (20) angeordnet ist und der sich durch die zumindest eine Abdeckplatte (56) hindurch erstreckt,
wobei der zumindest eine Positionierungspin (64) derart angeordnet ist, dass dieser in eine Leiterplatten-Öffnung (66) einer einzusetzenden Leiterplatte (72) einsetzbar ist.

11. Testkontaktorsystem umfassend:
einen Testkontaktor (10) gemäß einem der vorangehenden Ansprüche; und
zumindest eine Leiterplatte (72) mit einer Vielzahl von Halbleiterelementen (46), die in den Testkontaktor (10) eingesetzt ist.

12. Testkontaktorsystem gemäß Anspruch 11, wobei die zumindest eine Leiterplatte (72) austauschbar in den Testkontaktor (10) eingesetzt ist.

13. Testkontaktorsystem gemäß Anspruch 11 oder 12, wobei zumindest ein Positionierungspins (64) an einer der zumindest einen Abdeckplatte (56) zugewandten Seite des Basiselements (20) angeordnet ist und sich der zumindest eine Positionierungspin durch die zumindest eine Abdeckplatte (56) hindurch erstreckt,
wobei die zumindest eine Leiterplatte (72) zumindest eine Leiterplatten-Öffnung (66) aufweist, in die der zumindest eine Positionierungspin (64) zur Positionierung der Leiterplatte (72) eingesetzt ist.

14. Verwendung eines Testkontaktors (10) gemäß einem der oben genannten Ansprüche zum Testen von Halbleiterelementen (46).

15. Testverfahren zum Testen von Halbleiterelementen (46), umfassend:
Bereitstellen eines Testkontaktors (10) gemäß einer der vorangehenden Ansprüche;
Einsetzen einer Leiterplatte (72);
Schließen des Gehäuses (14);
Rückstellfähiges Bewegen der zumindest einen Abdeckplatte (56) in eine Richtung zu dem Basiselement (20) durch einen Anpresskraft, der im geschlossenen Zustand des Gehäuse-Deckels (78) mittels des zumindest einen Anpresselements (84) auf die zumindest eine Abdeckplatte (56) wirkt, so dass die Halbleiterelemente (46) durch Kontaktierungspins (48) kontaktiert werden;
Erhitzen des Testkontaktors (10) mit der zumindest einen eingesetzten Leiterplatte (72) auf eine vordefinierte Temperatur über eine vordefinierte Zeit; und
Kontaktieren der Halbleiterelemente (46) von einer Außenseite des Gehäuses (14) durch ein externes Auslesegerät und Testen der Halbleiterelemente (46).
